Europäisches Patentamt

European Patent Office

Office européen des brevets

(19)

(11) Veröffentlichungsnummer: **0 515 961 A1**

## (12) EUROPÄISCHE PATENTANMELDUNG

(21) Anmeldenummer: **92108473.7**

(22) Anmeldetag: **20.05.92**

(51) Int. Cl.5: **H02M 5/293**, G05F 1/445

(30) Priorität: **25.05.91 DE 4117122**

(43) Veröffentlichungstag der Anmeldung:
**02.12.92 Patentblatt 92/49**

(84) Benannte Vertragsstaaten:
**AT BE CH DE FR LI NL SE**

(71) Anmelder: **ABB PATENT GmbH**
**Kallstadter Strasse 1**
**W-6800 Mannheim 31(DE)**

(72) Erfinder: **Goldyn, Dirk**
**Leibredde 5**
**W-5810 Witten(DE)**
Erfinder: **Clever, Gerd**
**Halverscheid 2**
**W-5884 Halver(DE)**

(74) Vertreter: **Rupprecht, Klaus, Dipl.-Ing. et al**
**c/o ABB Patent GmbH, Postfach 10 03 51**
**W-6800 Mannheim 1(DE)**

(54) Schaltung zur Steuerung eines Wechselstromes.

(57) 2.1 Zur Steuerung eines einer Last zuzuführenden Wechselstromes verwendet man steuerbare Halbleiter, die in der Regel am Gleichspannungsausgang einer Gleichrichterbrücke liegen, so daß der Laststrom jeweils zwei Gleichrichterdioden und den steuerbaren Halbleiter durchfließen muß, bevor er die Last erreicht. Es soll eine Schaltung geschaffen werden, die mit geringerer Verlustleistung auskommt.

2.2 Als steuerbare Halbleiter dienen zwei mit ihren Schaltstrecken (TS1,TS2) in Reihe liegende Transistoren (T1,T2), wobei jeder Schaltstrecke (TS1,TS2) eine Inversdiode (D1,D2) parallel geschaltet ist. Die beiden Transistoren (T1,T2) sind so gepolt und gesteuert, daß jede der beiden Halbwellen des Wechselstroms (I) nur eine Inversdiode (D1,D2) und eine Schaltstrecke (TS1,TS2) auf dem Weg zur Last LA durchfließen muß.

2.3 Die Schaltung soll bevorzugt bei Dimmern zur Anwendung kommen.

EP 0 515 961 A1

Die Erfindung betrifft eine Schaltung zur Steuerung eines Wechselstromes mit Hilfe steuerbarer Halbleiter entsprechend der im Oberbegriff des Anpruchs 1 genannten Art.

Die Steuerung eines Wechselstromes mit elektronischen Hilfsmitteln zur Speisung einer Last kann sich auf einen reinen Ein-/Ausschaltvorgang beschränken, oder zusätzlich noch eine Stellfunktion, z.B. als Dimmer übernehmen. In beiden Fällen benötigt man für die elektronische Schaltung eine ausreichende Stromversorgung, die in der Regel aus der angeschlossenen Wechselspannungsquelle, also im allgemeinen dem Netz entnommen wird. Hierzu benötigt man allerdings einen Spannungsabfall an dem steuerbaren Halbleiter, sofern man die benötigte Versorgungsspannung nicht mit Hilfe eines Dreileiteranschlusses vom Spannungsabfall an der Last ableiten will.

Bei reinem Ein-/Ausschaltbetrieb, wie er z.B. bei einer automatischen Betätigung eines elektronischen Schalters durch einen Infrarotdetektor in Verbindung mit Türöffnern oder Beleuchtungseinrichtungen zur Anwendung kommt, entsteht während der Einschaltphase bei kurzgeschlossener Schaltstrecke kein für die Stromversorgung nutzbarer Spannungsabfall. Dieser wird deshalb künstlich mit Hilfe eines sog. Restphasenanschnittes erzeugt, wobei nur ein Teil der jeweiligen Wechselspannungshalbwelle zur Last durchgeschaltet wird, und der verbleibende Rest als Spannungsabfall am steuerbaren Halbleiter für die Stromversorgung zur Verfügung steht.

Entsprechend aufgebaute elektronische Dimmerschaltungen müssen so ausgelegt sein, daß auch hier bei größter Leistungsabgabe an die Last ein Restphasenanschnitt verbleibt. Zum Dimmen, das im Prinzip auf verschiedene Weise erfolgen kann, verwendet man meistens das Phasenanschnitt- oder das Phasenabschnittverfahren. Ein Phasenanschnitt, wird durch eine Verzögerung des Einschaltens der Last erreicht, wobei der Zündverzögerungswinkel oder auch kurz Zündwinkel genannt, dem Restphasenanschnitt entspricht. Der Phasenanschnitt endet beim Nulldurchgang der Wechselspannung, also am Ende der jeweiligen Wechselspannungshalbwelle. Er läßt sich mit allen steuerbaren Halbleitern, insbesondere auch mit Thyristoren und Triacs realisieren.

Beim Phasenabschnitt erfolgt keine Zündverzögerung, so daß die Schaltstrecke des steuerbaren Halbleiters bei Beginn der Halbwelle durchgeschaltet wird, aber entsprechend dem vorgegebenen Restphasenanschnitt vor dem Ende der jeweiligen Halbwelle abgeschaltet werden muß. Das Abschalten einer Spannung ist aber mit normalen Thyristoren oder Triacs nicht möglich, so daß hierbei bevorzugt Transistoren als steuerbare Halbleiter verwendet werden.

Damit möglichst die volle Wechselspannungsleistung für die Last zur Verfügung steht, müssen beide Halbwellen der Wechselspannung geschaltet und/oder gedimmt werden. So ist es u.a. aus der DE 37 43 556 A bekannt, einen steuerbaren Halbleiterschalter in die Diagonale der Gleichstromausgänge einer Gleichrichterbrücke zu legen, wobei diese mit ihren Wechselstromeingängen über eine in Reihe liegende Last mit einer Wechselspannungsqelle verbunden ist. Die Last ist in diesem Fall ein Triac, könnte aber bei geringerem Leistungsbedarf ebenso unmittelbar der Verbraucher sein. Entscheidend ist, daß es durch die Gleichrichterbrücke gelingt in beiden Halbwellen der Wechselspannung einen Phasenanschnitt zu erreichen.

Es ist weiterhin bekannt, entsprechend aufgebaute Schaltungen mit einem MOSFET als steuerbarem Halbleiter in einer Gleichrichterbrücke, als Phasenabschnittdimmer zu betreiben. Dabei entsteht jedoch nahezu die Hälfte der Verlustleistung durch die Gleichrichtung, da bei jeder Halbwelle zwei Gleichrichterdioden und der MOSFET vom Laststrom durchflossen werden, so daß nur eine relativ niedrige Anschlußleistung für die Last zur Verfügung steht.

Aufgabe der Erfindung ist es, ausgehend von dem erläuterten Stand der Technik eine Schaltung nach dem Oberbegriff des Anspruchs 1 zu schaffen, mit der es gelingt die Verlustleistung wesentlich zu reduzieren und dadurch die verfügbare Anschlußleistung bei gleicher Leistungsdichte der vorgesehenen Baueinheit, z.B. einem Unterputzdimmer, zu erreichen.

Diese Aufgabe wird durch die im Anspruch 1 gekennzeichneten Merkmale gelöst. Zweckmäßige Ausgestaltungen und Weiterbildungen des Anmeldungsgegenstandes sind in den Unteransprüchen genannt.

Dadurch, daß zu jedem der beiden in Reihe geschalteten Halbleiterschalter, die nur in einer Stromflußrichtung steuerbar sind, eine Inversdiode parallel geschaltet ist, gelingt es auf überraschend einfache Weise die Verlustleistung um etwa ein Drittel zu vermindern und die Anschlußleistung entsprechend zu erhöhen. Denn beide Halbwellen des Laststromes müssen nunmehr nur noch eine Diode und eine Schaltstrecke des jeweiligen Halbleiterschalters durchfließen.

In einer zweckmäßigen Ausgestaltung des Erfindungsgegenstandes ist vorgesehen, zwei Transistoren von gleichen Leitfähigkeitstyp zu verwenden, deren Schaltstrecken gegenpolig in Reihe geschaltet sind. Zum Anlegen des Steuersignals für die Steuerung der beiden Schaltstrecken dient ein zwischen ihnen gelegener Verbindungspunkt als Bezugspotential und die jeweilige Steuerelektrode der Transistoren als zweiter Anschluß. Ein Verbinden der beiden Steuerelektroden zu einem gemeinsamen Anschluß ermöglicht eine besonders einfache Ansteuerung.

Das Steuersignal muß von einer Steuerlogik erzeugt werden, die mit der Netzwechselspannung synchronsiert ist. Es ist vorteilhaft, das hierzu benötigte Synchronisiersignal von einem ersten Spannungsabfall abzuleiten, der durch den die Schaltstrecken der Transistoren durchfließenden Wechselstrom entsteht. Durch den über die Schaltstrecken der Transistoren fließenden Wechselstrom kann auch ein zweiter Spannungsabfall erzeugt werden, aus dem ein dem Wechselstrom proportionales Überlastsignal abgeleitet wird, das dann zur Steuerung einer Überlastlogik und/oder Kurzschlußlogik dient. Um ein möglichst genaues Überlastsignal zu erhalten, ist es zweckmäßig, den zweiten Spannungsabfall durch zwei zwischen die beiden Schaltstrecken eingefügte, mit diesen in Reihe liegende Sensorwiderstände zu erzeugen. Das zwischen den Schaltstrecken vorgesehene Bezugspotential kommt in diesem Fall zwischen den beiden Sensorwiderständen zu liegen, die zusammen mit zwei Summierdioden eine erste Gleichrichterbrücke bilden, die dafür sorgt, daß der an den Sensorwiderständen entstehende Spannungsabfall der beiden Wechselstromhalbwellen zu einem Überlastsignal summiert wird.

Eine besonders vorteilhafte Weiterbildung des Erfindungsgegenstandes besteht darin, daß die beiden in Reihe liegenden Schaltstrecken der Transistoren als zwei Zweige einer zweiten Gleichrichterbrücke angeordnet sind, deren weitere Zweige von zwei Netzteildioden gebildet werden. Es entsteht hierdurch eine Zweiweggleichrichterschaltung, mit einem künstlichen Nullpunkt, der dem Bezugspunkt entspricht und den ersten Gleichspannungsausgang der Gleichrichterbrücke bildet, deren zweiter Gleichspannungsausgang zwischen den beiden Netzteildioden liegt. Somit kann unmittelbar vom Gleichspannungsausgang dieser zweiten Gleichrichterbrücke eine Versorgungsspannung zur Speisung der Steuerlogik entnommen werden. Es ist zweckmäßig, die Versorgungsspannung durch einen Netzteilkondensator zu puffern und durch eine Zenerdiode zu begrenzen. Da die Steuerlogik nur eine geringe Versorgungsleistung benötigt, muß man den Strom durch die Netzteildioden mit Hilfe vorgeschalteter Netzteilwiderstände reduzieren. Zwischen der jeweiligen Netzteildiode und ihrem vorgeschalteten Netzteilwiderstand kann jeweils das zur Synchronisierung der Steuerlogik benötigte Synchronisiersignal abgegriffen werden.

Gemäß den einleitenden Ausführungen steht für die Erzeugung der Versorgungsspannung nur jeweils der während des Restphasenanschnittes an den Schaltstrecken der Transitoren entstehende Spannungsabfall zur Verfügung. Mit Hilfe eines Dreileiteranschlusses für die Schaltung wäre es möglich, auch den Spannungsabfall an der Last für die Stromversorgung heranzuziehen und dementsprechend den Restphasenanschnitt gegebenenfalls zu verringern.

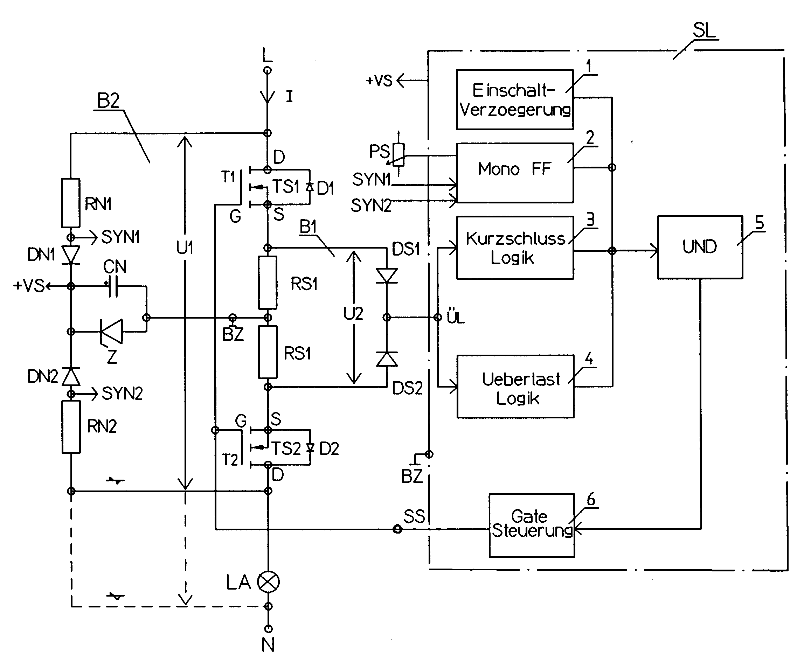

Ein Ausführungsbeispiel der Erfindung ist in der Zeichnung dargestellt und wird im folgenden näher erläutert.

Die dargestellte Schaltungsanordnung zeigt einen Nulleiteranschluß N und einen Phasenleiteranschluß L eines Wechselspannungsnetzes, zwischen denen eine Reihenschaltung liegt, die im wesentlichen aus einer Last LA und den Schaltstrecken TS1, TS2 zweier Schalttransistoren T1, T2 besteht. Bei den Schalttransistoren handelt es sich im vorliegenden Beispiel um zwei Power MOSFETS, deren durch Drain D und Source S gebildete Schaltstrecken TS1, TS2 gegenpolig in Reihe geschaltet sind. Zwischen den beiden Schaltstrecken TS1, TS2 liegt das Bezugspotential BZ, auf das alle Steuersignale und Hilfsspannungen bezogen sind.

Von einer Steuerlogik SL wird ein Steuersignal SS abgegeben, das zur Steuerung der beiden miteinander verbundenen, als Steuerelektrode dienenden Gates G der MOSFETS T1, T2 dient. Jede der beiden Schaltstrecken TS1, TS2 ist durch eine Inversdiode D1, D2 überbrückt.

Die insoweit beschriebene Grundschaltung arbeitet derart, daß beide MOSFETS T1, T2 entsprechend dem angelegten Steuersignal SS ihre Schaltstrecken TS1, TS2 gemeinsam ein- oder ausschalten. Bei eingeschalteten Schaltstrecken TS1, TS2 bestimmt die Polarität der jeweils anliegenden Halbwelle des die Last LA durchfließenden Wechselstroms I, welchen Weg dieser Strom nimmt. Bei einer auf den Nulleiter N bezogenen positiven Halbwelle und einem ebenfalls positiven Steuersignal SS, nimmt der Strom seinen Weg über die erste Schaltstrecke T1 des ersten MOSFETS T1 und die zweite Inversdiode D2 des zweiten MOSFETS T2. Bei einer negativen Halbwelle des Wechselstroms I fließt dieser dagegen über die Schaltstrecke TS2 des zweiten MOSFETS T2 und die erste Inversdiode D1 des ersten MOSFETS T1.

Um einen Schutz gegen Überlast und Kurzschluß zu erzielen, sind zwischen die beiden Schaltstrecken TS1, TS2 zwei Sensorwiderstände RS1, RS2 in Reihe liegend eingefügt, die einen dem Wechselstrom I proportionalen Spannungsabfall U2 erzeugen sollen. Mit Hilfe zweier Summierdioden DS1, DS2 wird eine erste Gleichrichterbrücke B1 gebildet, an derem Gleichspannungsausgang, zwischen den beiden Summierdioden DS1, DS2 und den beiden Sensorwiderständen RS1, RS2 ein Überlastsignal ÜL abgegriffen werden kann, das eine Sperrung der Schaltstrecken TS1, TS2 bewirkt, sobald der die Last LA durchfließende Wechselstrom I einen vorgegebenen Grenzwert überschreitet. Das Überlastsignal ÜL dient zur Steuerung einer Kurzschlußlogik 3 und einer Überlastlogik 4, die zur Steuerlogik SL gehören.

Zur Erzeugung einer Versorgungsspannung VS für die Steuerlogik SL dient eine zweite Brückenschaltung B2, bei der die MOSFET5 T1,T2 mit den zwischengeschalteten Sensorwiderständen RS1, RS2 je einen Zweig der zweiten Gleichrichterbrükke B2 und zwei Netzteildioden DN1, DN2 die beiden anderen Brückenzweige bilden. Jeder der beiden Netzteildioden DN1, DN2 ist noch ein Netzteilwiderstand RN1, RN2 vorgeschaltet, um den für die Versorgung benötigten Strom zu begrenzen. Der durch den Wechselstrom I an der Reihenschaltung der beiden Schaltstrecken TS1, TS2 und der beiden Sensorwiderstände RS1, RS2 entstehende spannungsabfall steht als Wechselspannung U1 an den Wechselspannungseingängen der Gleichrichterbrücke B2 zur Verfügung. Die an den Gleichspannungsausgängen der Gleichrichterbrücke B2 erzeugte Versorgungsspannung VS wird noch durch einen Kondensator CN gepuffert und durch eine Zenerdiode Z auf einen vorgegebenen Wert begrenzt.

An den beiden Netzteildioden DN1, DN2, zwischen diesen und den vorgeschalteten Netzteilwiderständen RN1, RN2 wird jeweils ein Synchronisiersignal SYN1, SYN2 abgegriffen und einem Monoflipflop 2 der Steuerlogik SL zugeführt.

Zur Steuerlogik SL gehören außer dem Monoflipflop 2, der Kurzschlußlogik 3 und der Überlastlogik 4 noch eine Einschaltverzögerung 1. Letztere hat die Aufgabe, die Ansteuerung der MOSFETS T1,T2 solange zu unterbinden, bis der Netzteilkondensator CN genügend aufgeladen ist. Das für die Synchronisierung des Steuersignals SS dienende Monoflipflop 2 ist noch mit einem Potentiometer PS versehen, mit dem es möglich ist, den Steuerwinkel des Phasenan- bzw. -abschnitts entsprechend der gewählten Dimmstellung zu verändern. Die Kurzschlußlogik 3 ist so ausgewählt, daß sie bei ca. 5-fachem Nennstrom innerhalb weniger Mikrosekunden anspricht und ein Signal abgibt, während die Überlastlogik bei dem ca. 1,2-fachen Nennstrom mit einer Verzögerung von ca. 100 Millisekunden ein Ausgangssignal abgibt. Die von den erläuterten Logikeinheiten 1 bis 4 abgegebenen Signale werden einem UND-Gatter 5 zugeführt, dessen Ausgang mit dem Eingang einer Gatesteuerung 6 verbunden ist, die ihrerseits das zur Steuerung der beiden MOSFETS T1, T2 benötigte Steuersignal SS abgibt. Die Steuerlogik SL kann mit bekannten integrierten Steuerbausteinen, z.B. einem Vierfach-Nor-Gatter vom Typ 4001 aufgebaut werden.

Wegen des wesentlich geringeren Verdrahtungsaufwandes versucht man in der Praxis die Schaltungsanordnung so aufzubauen, daß diese mit einem Zweileiteranschluß auskommt. Andererseits wird der Dimmbereich in unerwünschter Weise eingeschränkt, weil ein Restphasenanschnitt von etwa 3 Millisekunden für die Ladung des Netzteils benötigt wird, und somit die Stromflußzeit auf ca. 7 Millisekunden pro Halbwelle begrenzt werden muß. Bei einem Dreileiteranschluß, wie er in der Schaltung durch eine gestrichelte Linie angedeutet ist, kann auch der Spannungsabfall an der Last LA für die Stromversorgung herangezogen werden und dementsprechend der erforderliche Restphasenanschnitt vermindert werden oder sogar ganz wegfallen.

Je nach Art des durch die Steuerlogik SL erzeugten Steuersignals SS kann die Schaltung als Phasenanschnitt- oder -abschnittdimmer arbeiten. Der Anschnittart entsprechend müssen auch die steuerbaren Halbleiter T1,T2 gewählt werden. Für den Phasenabschnitt kommen außer normalen bipolaren Transistoren und MOSFETS (Metalloxid-Halbleiter-Feldeffekttransistoren) z.B. auch IGBTS (bipolare Transistoren mit isoliertem Gate) in Frage. Abhängig vom jeweiligen Halbleiterschalter ist es gegebenenfalls notwendig, als Inversdiode eine diskrete Diode oder ein anderes Bauteil mit geeigneter Gleichrichterfunktion zu verwenden. Selbst bei MOSFETS, die mit integrierten Inversdioden hergestellt werden, kann es ratsam sein, eine Inversdiode mit höherer Leistung extern zuzuschalten.

**Patentansprüche**

1. Schaltung zur Steuerung eines Wechselstromes (I) mit Hilfe steuerbarer Halbleiter, die in Abhängigkeit von einem Steuersignal (SS) mindestens einen Teil der positiven oder negativen Halbwelle des Wechselstromes (I) einer Last (LA) zuführen, wobei die Last (LA), mindestens ein steuerbarer Halbleiter und eine Wechselstromquelle (L-N) in Serie geschaltet sind, dadurch gekennzeichnet, daß als steuerbare Halbleiter zwei mit ihren Schaltstrecken (TS1,TS2) in Reihe liegende Transistoren (T1,T2) dienen und jeder Schaltstrecke (TS1,TS2) eine Inversdiode (D1,D2) parallelgeschaltet ist und daß die beiden Transistoren (T1,T2) so gepolt und gesteuert sind, daß bei einer eingeschalteten ersten Schaltstrecke (TS1) des ersten Transistors (T1) ein während einer ersten Halbwelle fließender Strom über die erste Schaltstecke (TS1) und die Inversdiode (D2) des zweiten Transistors (T2) fließt und bei einer eingeschalteten zweiten Schaltstrecke (TS2) des zweiten Transistors (T2) ein während der zweiten Halbwelle fließender Strom über die zweite Schaltstrecke (TS2) und die Inversdiode (D1) des ersten Transistors (T1) fließt.

2. Schaltung nach Anspruch 1, dadurch gekennzeichnet, daß der beiden Transistoren (T1,T2) vom gleichen Leitfähigkeitstyp sind und ihre Schaltstrecken (TS1,TS2) gegenpolig in Reihe geschaltet sind und das Steuersignal (SS) zwischen den Steuerelektroden (G) der Transistoren (T1,T2) und einem zwischen den beiden Schaltstrecken (TS1,TS2) liegenden Bezugspotential (BZ) anliegt, wobei die beiden Steuerelektroden (G) vorzugsweise miteinander verbunden sind.

3. Schaltung nach einem der vorhergehenden Ansprüche, dadurch gekennzeichnet, daß das Steuersignal (SS) von einer Steuerlogik (SL) erzeugt wird und zur Synchronisierung der Steuerlogik (SL) dienende Synchronisiersignale (SYN1,SYN2) von einem ersten Spannungsabfall (U1) abgeleitet sind, der durch den die Schaltstrecken (TS1,TS2) der Transistoren (T1,T2) durchfließenden Wechselstrom (I) entsteht.

4. Schaltung nach einem der vorhergehenden Ansprüche, dadurch gekennzeichnet, daß von einem zweiten Spannungsabfall (U2), den der über die Schaltstecken (TS1,TS2) der Transistoren (T1,T2) fließende Wechselstrom (I) erzeugt, ein diesem Wechselstrom (I) proportionales Überlastsignal (ÜL) abgeleitet und einer der Steuerlogik (SL) zugeordneten Überlastlogik (4) und/oder Kurzschlußlogik (3) zugeführt ist.

5. Schaltung nach einem der vorhergehenden Ansprüche, dadurch gekennzeichnet, daß der zweite Spannungsabfall (U2) durch zwei zwischen die beiden Schaltstrecken (TS1,TS2) eingefügte, mit diesen in Reihe liegende Sensorwiderstände (RS1,RS2) erzeugt wird, derart, daß das Bezugspotential (BZ) zwischen ihnen zu liegen kommt, und daß das dem zweiten Spannungsabfall (U2) proportionale Überlastsignal (ÜL) am Gleichstromausgang einer ersten Gleichrichterbrücke (B1) zwischen dem Bezugspotential (BZ) und dem Verbindungspunkt einer am ersten Sensorwiderstand (RS1) anliegenden ersten Summierdiode (DS1) und einer am zweiten Sensorwiderstand (RS2) anliegenden zweiten Summierdiode (DS2) entnommen wird.

6. Schaltung nach einem der vorhergehenden Ansprüche, dadurch gekennzeichnet, daß der erste Spannungsabfall (U1) an der Reihenschaltung entsteht, die die beiden Schaltstrecken (TS1,TS2) mit oder ohne die beiden Sensorwiderstände (RS1,RS2) bilden, und dieser Spannungsabfall (U1) am Wechselspannungseingang einer zweiten Gleichrichterbrücken (B2) anliegt, die ihrerseits durch die Reihenschaltung und mindestens zwei Netzteildioden (DN1,DN2) gebildet wird und an derem Gleichstromausgang, zwischen den Netzteildioden (DN1,DN2) und dem Bezugspotential (BZ), eine Versorgungsspannung (VS) für die Steuerlogik (SL) abgegriffen wird.

7. Schaltung nach Anspruch 6, dadurch gekennzeichnet, daß die Versorgungsspannung (VS) durch einen Netzteilkondensator (CN) gepuffert und durch eine Zenerdiode (Z) begrenzt ist, wobei die Parallelschaltung von Netzteilkondensator (CN) und Zenerdiode (Z) zwischen den Netzteildioden (DN1,DN2) und Bezugspotential (BZ) liegt.

8. Schaltung nach einem der vorhergehenden Ansprüche, dadurch gekennzeichnet, daß den beiden Netzteildioden (DN1,DN2) je ein Netzteilwiderstand (RN1,RN2) vorgeschaltet ist, und zwischen dem ersten Netzteilwiderstand (RN1) und der ersten Netzteildiode (DN1) ein erstes Synchronisiersignal (SYN1) und zwischen dem zweiten Netzteilwiderstand (Rn2) und der zweiten Netzteildiode (DN2) ein zweites Synchronisiersignal (SYN2) abgegriffen und der Steuerlogik (SL) zugeführt wird.

9. Schaltung nach einem der vorhergehenden Ansprüche, dadurch gekennzeichnet, daß der zweite Spannungsabfall (U2) der Netzwechselspannung entspricht, die an der durch die Last (LA) und die Reihenschaltung gebildeten Gesamtreihenschaltung anliegt.

10. Schaltung nach einem der vorhergehenden Ansprüche, dadurch gekennzeichnet, daß die Steuerlogik (SL) außer einer Überlastlogik (4) und gegebenenfalls einer Kurzschlußlogik (3) noch ein Monoflipflop (2) und eine Einschaltverzögerung besitzt, die mit ihren Ausgängen dem Eingang eines UND-Gatters (5) zugeführt sind und an dessen Ausgang eine das Steuersignal (SS) erzeugende Gatesteuerung (6) liegt.

11. Schaltung nach Anspruch 10, dadurch gekennzeichnet, daß dem Monoflipflop (2) eingangsseitig die Synchronisiersignale (SYN1,SYN2) und das Stellsignal eines Stellpotentiometers (PS) zur Vorgabe eines Stromflußwinkels zugeführt sind.

12. Schaltung nach einem der vorhergehenden Ansprüche, dadurch gekennzeichnet, daß das von der Steuerlogik (SL) erzeugte Steuersignal (SS) die Transistoren (T1,T2) so steuert, daß die Schaltung als Phasenabschnittdimmer, als Phasenanschnittdimmer oder als Impulsgruppendimmer arbeitet.

13. Schaltung nach einem der vorhergehenden Ansprüche, dadurch gekennzeichnet, daß die beiden Transistoren (T1,T2) bipolare Transistoren, FETS, insbesondere MOSFETS, oder IGBTS sind und die beiden Inversdioden (D1,D2) als diskrete oder integrierte Bauteile mit den Transistoren (T1,T2) verbunden sind.

| Kategorie | Kennzeichnung des Dokuments mit Angabe, soweit erforderlich, der maßgeblichen Teile | Betrifft Anspruch | KLASSIFIKATION DER ANMELDUNG (Int Cl.⁵) |
|---|---|---|---|
| | **EINSCHLÄGIGE DOKUMENTE** | | EP 92108473.7 |
| A | <u>DE - A - 3 432 225</u><br>(BLOOMER)<br>  * Seite 12, Seiten 3-26;<br>  Fig. 2b; Ansprüche 1,3,5,9,<br>  14-18,22,23 *<br>  -- | 1,2,5,<br>12,13 | H 02 M 5/293<br>G 05 F 1/445 |
| A | <u>WO - A - 91/06 047</u><br>(SCHANIN)<br>  * Seite 5, Zeile 22 - Seite<br>  6, Zeile 6; Fig. 1;<br>  Ansprüche 1,2,3,7-10 *<br>  -- | 1,10,<br>12,13 | |
| A | <u>EP - A - 0 311 995</u><br>(HAJAGOS et al.)<br>  * Spalte 5, Zeile 42 -<br>  Spalte 6, Zeile 2; Fig. 3;<br>  Anspruch 1 *<br>  -- | 1,13 | |
| D,A | <u>DE - A - 3 743 556</u><br>(BLOMBERG)<br>  * Anspruch 9 *<br>  ---- | 7 | |
| | | | RECHERCHIERTE SACHGEBIETE (Int. Cl.⁵) |
| | | | H 02 M<br>G 05 F |

Der vorliegende Recherchenbericht wurde für alle Patentansprüche erstellt.

| Recherchenort | Abschlußdatum der Recherche | Prüfer |
|---|---|---|
| WIEN | 02-09-1992 | MEHLMAUER |